Europäisches Patentamt

European Patent Office

Office européen des brevets

(19)

(11) Veröffentlichungsnummer : **0 288 528 B1**

(12) **EUROPÄISCHE PATENTSCHRIFT**

(45) Veröffentlichungstag der Patentschrift :
03.06.92 Patentblatt 92/23

(51) Int. Cl.⁵ : **G01R 1/073**

(21) Anmeldenummer : 87907298.1

(22) Anmeldetag : 07.11.87

(86) Internationale Anmeldenummer :
**PCT/DE87/00503**

(87) Internationale Veröffentlichungsnummer :
**WO 88/03651 19.05.88 Gazette 88/11**

(54) **VORRICHTUNG ZUM PRÜFEN VON ELEKTRISCHEN LEITERPLATTEN.**

(30) Priorität : **11.11.86 DE 3638372**

(43) Veröffentlichungstag der Anmeldung :
**02.11.88 Patentblatt 88/44**

(45) Bekanntmachung des Hinweises auf die
Patenterteilung :
**03.06.92 Patentblatt 92/23**

(84) Benannte Vertragsstaaten :
**AT BE CH DE FR GB IT LI LU NL SE**

(56) Entgegenhaltungen :
**EP-A- 0 135 384**
**EP-A- 0 194 805**

(56) Entgegenhaltungen :
**DE-A- 3 211 410**
**DE-A- 3 312 436**
**DE-B- 2 559 004**
**US-A- 4 290 015**

(73) Patentinhaber : **LANG-DAHLKE, Helmut**
**Burkheimer Strasse 9**
**W-7800 Freiburg (DE)**

(72) Erfinder : **LANG-DAHLKE, Helmut**
**Burkheimer Strasse 9**
**W-7800 Freiburg (DE)**

(74) Vertreter : **Goy, Wolfgang, Dipl.-Phys.**
**Richard-Wagner-Strasse 55**
**W-7800 Freiburg (DE)**

EP 0 288 528 B1

## Beschreibung

Die Erfindung betrifft eine Vorrichtung zum Prüfen von elektrischen Leiterplatten mit einer Vielzahl von gegen die Prüfpunkte auf der zu prüfenden Leiterplatte federnd andrückbaren und mit einer Auswerteschaltung verbundenen Nadeln wobei die Nadeln auf der der zu prüfenden Leiterplatte zugewandten Seite eines Zwischenadapters in einem prüflingsspezifischen Muster angeordnet sind, wobei dem Zwischenadapter auf der von der Leiterplatte wegweisenden Seite ein Rasterkontaktfeld eines Grundadapters mit einer ersten Rasterschrittweite zugeordnet ist, das über federnde Kontaktelemente und eine Verdrahtung an die Nadeln anschließbar ist.

Eine derartige Prüfvorrichtung für elektrische Leiterplatten ist aus der EP-A-O 135 384 bekannt. Zu diesem Zweck ist zunächst ein plattenförmiger Grundadapter mit einem regelmäßigen Rasterkontaktfeld mit einer bestimmten Rasterschrittweite vorgesehen. Auf diesen Grundadapter wird ein Zwischenadapter aufgesetzt, der unterseitig entsprechend dem Rasterkontaktfeld des Grundadapters Kontaktverbindungen in Form von Drahtenden aufweist, so daß jedem Drahtende ein entsprechender Kontakt des Grundadapters zugeordnet ist. Im oberen Bereich weist der Zwischenadapter zwei zueinander parallele Kunststoffplatten auf. Entsprechend dem prüflingsspezifischen Muster der Prüfpunkte der zu testenden Leiterplatte sind in diese beiden Kunststoffplatten miteinander fluchtend Bohrungen eingebracht und in diese Bohrungen federnde Nadeln in einer speziellen Aufnahmevorrichtung eingesetzt. Auf diese Nadeln wird die zu prüfende Leiterplatte mit den entsprechenden Prüfpunkten aufgesetzt und die Prüfung mittels einer angeschlossenen Auswerteschaltung durchgeführt.

Nachteilig bei dieser bekannten Prüfvorrichtung ist, daß zum Prüfen unterschiedlicher Leiterplatten jeweils unterschiedliche Zwischenadapter benötigt werden. Dies ist technisch sehr aufwendig und kostspielig, da entsprechende Bohrungen in den Zwischenadapter eingebracht und anschließend die Nadeln eingesetzt werden müssen. Wollte man die bekannte Prüfvorrichtung darüber hinaus zum Prüfen von Leiterplatten mit den seit einiger Zeit im Einsatz befindlichen SMD-Bauelementen verwenden, bei denen die Landeflächenbilder oder Lötbilder für die Lötanschlüsse der SMD-Bauelemente in einem kleineren Raster, beispielsweise einem Raster mit einer Schrittweite von 1/20 Zoll, angeordnet sind, so ergeben sich bei einem derartigen Vollrasteradapter zur Kontaktierung im Rasterschritt mit 1/20 Zoll gegenüber einem Adapter mit einem Raster von 1/10 Zoll eine vierfache Anzahl von Anschlußpunkten, wodurch sowohl technische Probleme auftreten als auch steigende Kosten. Besondere Probleme ergeben sich auch dann, wenn die Leiterplatte einerseits im 1/10 Zoll-Raster kontaktiert werden soll und andererseits im Bereich der SMD-Bauelemente mit einem Raster einer Schrittweite von 1/20 Zoll kontaktiert werden muß. Einerseits ergibt sich dadurch im Bereich der SMD-Bauelemente eine hohe Anschlußpunktdichte und andererseits liegen die Rasterpunkte des kleineren Rasters nur in Ausnahmefällen in Abständen von den Rasterpunkten des weiteren Rasterfel des, die ein Vielfaches der Rasterschrittweite des kleineren Rasterfel des betragen.

Davon ausgehend liegt der Erfindung die **Aufgabe** zugrunde, die bekannte Vorrichtung zum Prüfen von elektrischen Leiterplatten derart weiterzuentwickeln, daß damit eine Möglichkeit geschaffen wird, elektrische Leiterplatten mit unterschiedlichen prüflingsspezifischen Mustern zu prüfen, ohne daß eine Vielzahl von Zwischenadaptern bereitgehalten werden muß, bei denen alle Nadeln einzel montiert und verdrahtet werden müssen.

Als technische **Lösung** wird mit der Erfindung vorgeschlagen, daß in an prüflingsspezifischen Stellen des Zwischenadapters befindlichen Fenstern prüflingsspezifische, auswechselbare Umsetzer eingesetzt sind, die einen Teil der Nadeln aufweisen, welche den Prüfpunkten einer zweiten Rasterschrittweite gruppenweise zugeordnet sind, und daß die Umsetzer auf der den Nadeln gegenüberliegenden Seite die Kontaktelemente in der ersten Rasterschrittweite tragen.

Eine nach dieser technischen Lehre ausgebildete Vorrichtung zum Prüfen von elektrischen Leiterplatten hat den Vorteil, daß vorgefertigte Umsetzer verwendet werden, auf denen gruppenweise Nadeln zusammengefaßt sind, so daß der Zwischenadapter mit Hilfe von Bausteinen unter Verwendung derartiger Umsetzer zusammengesetzt werden kann, die in nur verhältnismäßig wenigen unterschiedlichen Ausführungen bereitgehalten werden müssen. Insbesondere eignet sich die Prüfvorrichtung für elektrische Leiterplatten, die mit SMD-Bauelementen bestückt werden, bei denen die Landeflächenbilder oder Lötbilder für die Lötanschlüsse der SMD-Bauelemente in einem kleineren Raster, beispielsweise einem Raster mit einer Schrittweite von 1/20 Zoll, angeordnet sind. Somit können problemlos Leiterplatten überprüft werden, die einerseits im 1/10 Zoll-Raster kontaktiert werden sollen und andererseits im Bereich der SMD-Bauelemente mit einem Raster einer Schrittweite von 1/20 Zoll kontaktiert werden müssen.

Vorteilhafte Weiterbildungen ergeben sich aus den Unteransprüchen.

Nachfolgend wird ein Ausführungsbeispiel der Erfindung unter Bezug auf die Zeichnung näher erläutert. Es zeigen:

2

Fig. 1 einen Zwischenadapter einer Vorrichtung zum Prüfen von elektrischen Leiterplatten zusammenn mit der zu prüfenden Leiterplatte und dem Kontaktflächenfeld eines Grundadapters der Vorrichtung,

Fig. 2 einen prüflingsspezifischen Umsetzer zum Einsatz in den Zwischenadapter gemäß Fig. 1,

Fig. 3 eine Draufsicht auf die zur Leiterplatte weisende Oberseite des Umsetzers gemäß Fig. 2 zur Veranschaulichung der Lage der Kontaktnadeln und der Kontaktstifte des Umsetzers und

Fig. 4 vier Drehpositionen des Umsetzers zur Veranschaulichung der Verschiebung der Kontaktstifte bei einer Drehung des Umsetzers um 90°, 180° und 270°.

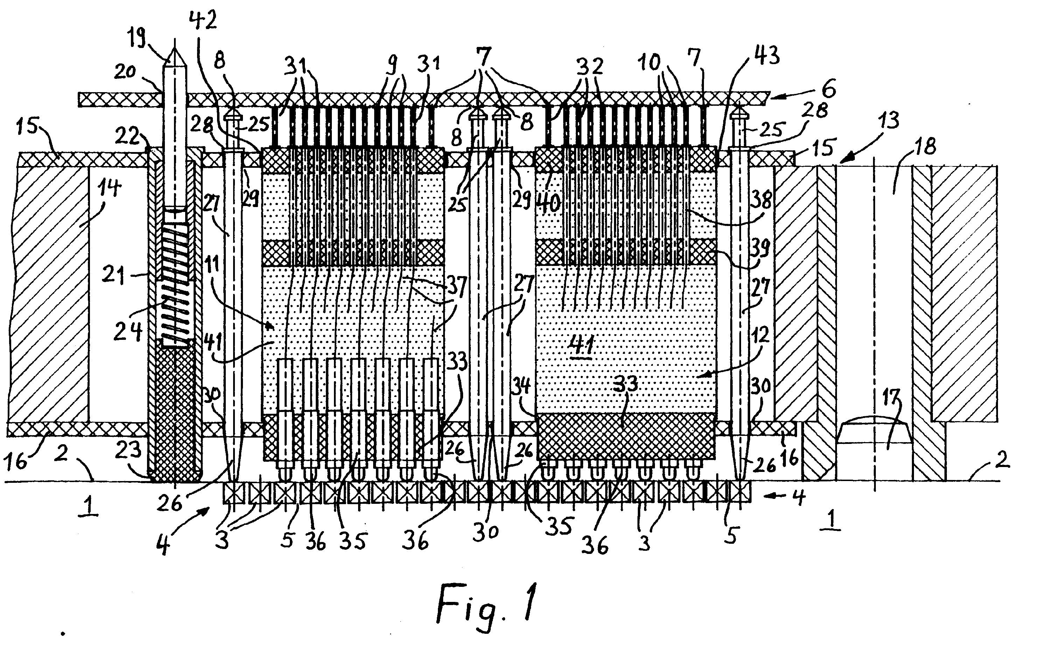

In Fig. 1 erkennt man schematisch den Aufbau der Vorrichtung zum Prüfen von elektrischen Leiterplatten in einem Schnitt entlang einer rechtwinklig zur Ebene der Leiterplatte verlaufenden Ebene. Die Vorrichtung verfügt über einen Grundadapter 1, der entlang seiner Oberfläche 2 mit einer Vielzahl von Kontaktflächen 3 eines Kontaktflächenfeldes 4 versehen ist. Die Kontaktflächen 3 sind in einem Raster mit einer Rasterschrittweite von 1/10 Zoll angeoldnet. Zwischen den Kontaktflächen befinden sich nichtleitende Zwischenräume 5. Die Kontaktflächen 3 sind über in der Zeichnung nicht dargestellte Leitungen mit einer Auswerteschaltung verbunden, die es gestattet, eine in Fig. 1 oben gezeichnete Leiterplatte 6 mit Lötflächen 7 und in der Zeichnung nicht dargestellten Leiterbahnen durch Kontaktieren an einer Vielzahl von Prüfpunkten zu testen. Die Leiterplatte 6 ist in Fig. 1 eine unbestückte Leiterplatte, die als Prüfling der Vorrichtung zum Prüfen von elektrischen Leitplätten zugeführt wird. Auf der Leiterplatte 6 sind erste Prüfpunkte 8 mit einer Rasterschrittweite von 1/10 Zoll sowie zweite Prüfpunkte 9 und dritte Prüfpunkte 10 vorgesehen, die den Landeflächen von SMD-Bauelementen zugeordnet sind und eine Rasterschrittweite von 1/20 Zoll aufweisen.

Bei der in Fig. 1 dargestellten Leiterplatte 6 liegt jeder zweite Prüfpunkt 9 auf dem gleichen Raster wie die ersten Prüfpunkte 8. Die dritten Prüfpunkte 10 sind gegenüber dem durch die ersten Prüfpunkte 8 und dem durch die zweiten Prüfpunkte 9 definierten Rasternetz verschoben, weshalb ein weiter unten erörterter Lageausgleich mit Hilfe von Umsetzern 11, 12 vorgenommen wird.

Die Umsetzer 11, 12 sind in einem Zwischenadapter 13 herausnehmbar eingesetzt, der, wie in Fig. 1 zu erkennen ist, zwischen der Leiterplatte 6 und dem Grundadapter 1 angeordnet ist. Der Zwischenadapter 13 verfügt über einen Aufnahmerahmen 14, durch den eine obere Kontaktträgerplatte 15 und eine untere Kontaktträgerplatte 16 im Abstand voneinander fixiert sind.

Der Zwischenadapter 13 wird mit Hilfe von Positionierstiften 17, die aus der Oberfläche 2 des Grundadapters 1 hinausragen, gegenüber dem Grundadapter 1 gegen Verschieben in Richtung der Oberflächenebene 2 gesichert. Dazu sind für die Positionierstifte 17 im Zwischenadapter 13 Ausnehmungen 18 vorgesehen, von denen eine in Fig. 1 dargestellt ist.

Die Fixierung der Leiterplatte 6 gegenüber dem Zwischenadapter 13 erfolgt mit Hilfe von Fangstiften 19, von denen einer in Fig. 1 zu erkennen ist. Der Fangstift 19 ragt durch eine Fangbohrung 20 in der Leiterplatte 6 hindurch. Die Lage der Fangstifte 19 und der Fangbohrungen 20 ist prüflingsspezifisch. Der Fangstift 19 ist in einer Fangstifthülse 21 geführt, die an ihrem oberen Ende mit einem Anschlagring 22 und an ihrem unteren Ende mit einem Fuß 23 versehen ist. Im Innern der Fangstifthülse 21 befindet sich eine Spiralfeder 24.

In der oberen Kontaktträgerplatte 15 und der unteren Kontaktträgerplatte 16 befinden sich jeweils paarweise miteinander fluchtende Öffnungen 29, 30, 42, 43 für Tastnadeln 25 und Taststifte 26 sowie für die prüflingsspezifisch ausgebildeten und angeordneten Umsetzer 11, 12.

Die Tastnadeln 25 sind in Tastnadelhülsen 27 mit einem Anschlagbund 28 federnd geführt. Die unteren Enden der Tastnadelhülsen 27 gehen jeweils in die Taststifte 26 über. Die Tastnadelhülsen 27 mit den Tastnadeln 25 können leicht ausgewechselt werden, so daß im Zwischenadapter 13 nur diejenigen Stellen mit Tastnadeln 25 belegt sind, an denen eine Kontaktierung des Prüflings 6 erfolgen soll. Die den Tastnadeln 25 und den Taststiften 26 zugeordneten Bohrungen 29 und 30 liegen auf einem Raster, dessen Rasterschrittweite ebenso wie die Rasterschrittweite der Kontaktflächen 3 des Grundadapters 1 1/10 Zoll beträgt.

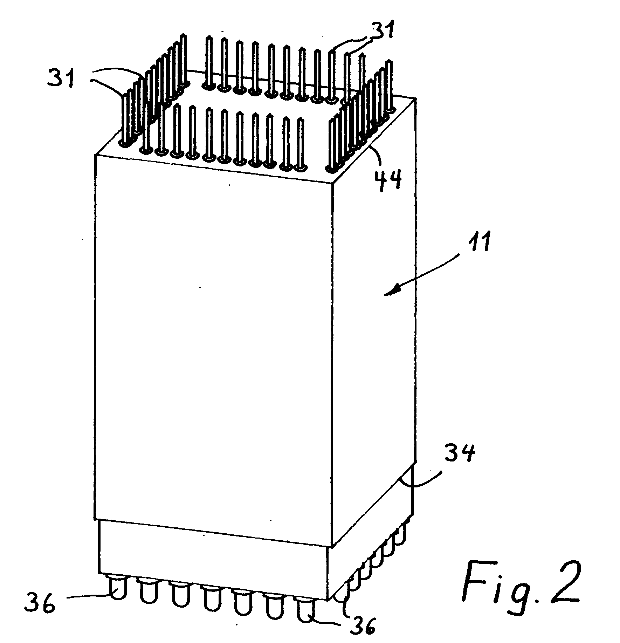

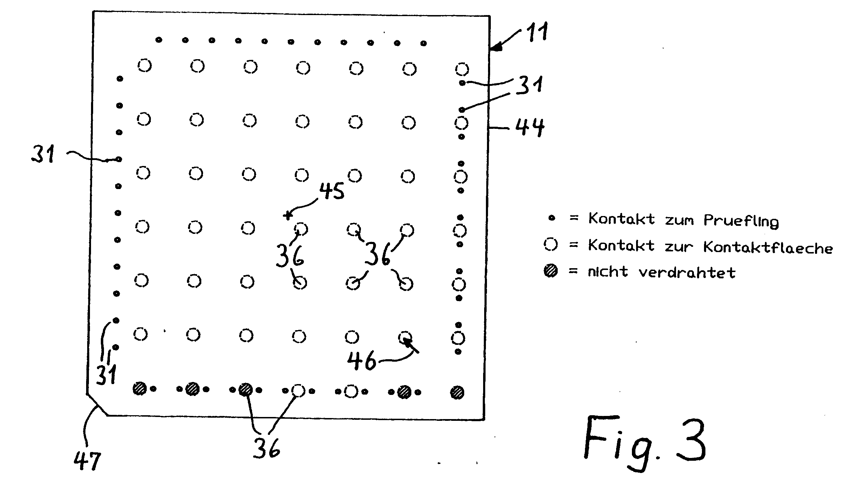

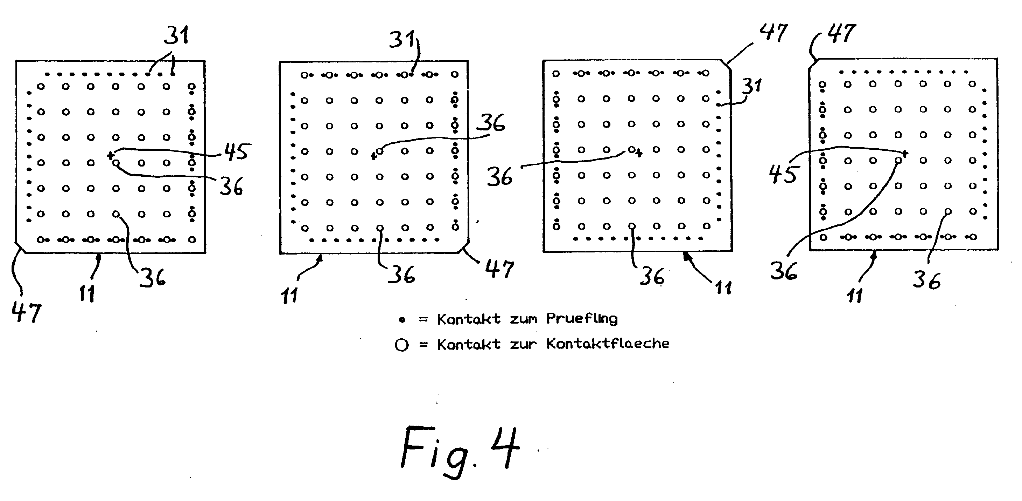

An den Stellen, an denen auf dem Prüfling-6 Lötflächen 7, zweite Prüfpunkte 9 oder dritte Prüfpunkte 10 außerhalb des groben 1/10 Zoll-Rasters, beispielsweise für die Landeflächen von SMD-Bauelementen kontaktiert werden sollen, sind die Umsetzer 11, 12 mit Kontaktnadeln 31 bzw. 32 vorgesehen. Die Anordnung der Kontaktnadeln 31, 32 ist in Fig. 2 perspektivisch und in den Figuren 3 und 4 in einer Draufsicht zu erkennen. Die dargestellte Anordnung stellt einen Spezialfall für ein SMD-Bauelement dar. Selbstverständlich können die Kontaktnadeln 31, 32 der Umsetzer 11, 12 der Anordnung der Landeflächen beliebiger SMD-Bauelemente angepaßt werden. Die Umsetzer 11, 12 gestatten dabei eine Umsetzung der Rasterlage der Lötflächen für die Landeflächen der SMD-Bauelemente, die jeweils prüflingsspezifisch für eine Leiterplatte 6 sind, an das fest vorgegebene Raster des Grundadapters 1, obwohl die Rasterschrittweiten im Grundadapter 1 und den Landeflächen der SMD-Bauelemente verschieden sind, und die Lötflächen der SMD-Bauelemente auf der Leiterplatte 6 nicht in das 1/10 Zoll-Raster der Tastnadeln 25 oder in ein diesem Raster gegenüber fest verschobenen Raster fallen.

Die Umsetzer 11, 12 verfügen jeweils über eine Grundplatte 33 mit einem Anschlagrand 34. In der Grundplatte 33 sind entsprechend dem Raster der Kontaktflächen 3 Kontaktstifthülsen 35 zur Führung von Kontaktstiften 36 befestigt. Die Kontaktstifte 36 sind in den Kontaktstifthülsen 35 federnd gelagert und über eine Verdrahtung 37 mit Kontaktnadelhülsen 38 elektrisch verbunden, in denen die Kontaktnadeln 31, 32 federnd geführt sind. Die Kontaktnadelhülsen 38 erstrecken sich zwischen einer Zwischenplatte 39 und einer Abschlußplatte 40. Die Zwischenräume zwischen der Abschlußplatte 40 und der Zwischenplatte 39 und der Zwischenplatte 39 und der Grundplatte 33 sind mit einer Füllmasse 41, beispielsweise einem Polyesterharz ausgegossen.

Zur Aufnahme der Umsetzer 11, 12 sind in der oberen Kontaktträgerplatte 15 sowie der unteren Kontaktträgerplatte 16 an jeweils prüflingsspezifischen Stellen quadratische Fenster 42 und 43 vorgesehen. Der seitliche Abstand zwischen den Fenstern 42 beträgt nichtnotwendigerweise ein Vielfaches der Rasterschrittweite der Kontaktstifte 36 oder der Kontaktflächen 3. Aus diesem Grunde sind die Umsetzer 11, 12 bezüglich ihrer Mittellängsachsen unsymmetrisch aufgebaut, was am besten in Fig. 3 zu erkennen ist. Der in Fig. 1 dargestellte Umsetzer 12 ist gegenüber dem in Fig. 1 dargestellten Umsetzer 11 um seine im rechten Winkel zur Oberfläche 2 verlaufende Längsachse um 180° gedreht.

In Fig. 2 erkennt man in perspektivischer Ansicht einen Umsetzer 11 mit den Kontaktnadeln 31, die entsprechend dem Muster eines SMD-Bauelementes aus der Oberseite des Umsetzers 11 hervorspringen. An der Unterseite des Umsetzers 11 sind die Kontaktstifte 36 zu erkennen, die entsprechend dem üblichen 1/10 Zoll-Raster angeordnet sind.

In Fig. 3 ist in einer Draufsicht die Lage der Kontaktnadeln 31 und der Kontaktstifte 36 dargestellt. Den 44 dargestellten Kontaktnadeln 31 sind eine entsprechende Anzahl von verdrahteten Kontaktstiften 36 zugeordnet, Nichtverdrahtete Kontaktstifte 36 sind in Fig. 3 schraffiert ausgefüllt.

Wie man in Fig. 3 erkennen kann, haben die Kontaktnadeln 31 von den Seitenkanten 44 überall den gleichen Abstand. Im Bezug auf einen in Fig. 3 eingezeichneten Mittelpunkt 45 ergibt sich sowohl für die Seitenkanten 44 als auch für die Kontaktnadeln 31 eine Punktsymmetrie.

Wie man in Fig. 3 weiter erkennt, ist das Rasterfeld der Kontaktstifte 36 gegenüber dem Mittelpunkt 45 nicht punktsymmetrisch sondern gegenüber einer punktsymmetrischen Anordnung in Richtung des Pfeiles 46 um 1/40 Zoll oder 1/4 der Rasterschrittweite der Kontaktstifte 36 horizontal und vertikal verschoben. Durch diese Verschiebung ist es möglich, trotz nicht aufeinanderpassender Rasterungen in der Leiterplatte 6 und dem Grundadapter 1 eine Kontaktierung der Prüfpunkte auf der Leiterplatte 6 durchzuführen.

Zur Veranschaulichung der Auswirkungen der Verschiebung des Rasters der Kontaktstifte 36 ist in Fig. 3 und Fig. 4 eine Ecke 47 zur Markierung abgeschrägt.

Geht man von der in Fig. 3 und in Fig. 4 ganz links gezeigten Ausgangsstellung des Umsetzers 11 aus, so bewirkt ein Herausnehmen des Umsetzers 11 aus den Fenstern 42, 43 und ein um 90° um den Mittelpunkt 45 versetztes Wiedereinsetzen des Umsetzers 11, daß die Kontaktstifte 36 gegenüber der ursprünglichen Lage um einen halben Rasterschritt oder 1/20 Zoll in Fig. 4 nach unten verschoben werden.

Eine weitere Verdrehung des Umsetzers 11 mit einer Gesamtdrehung von 180° ergibt die dritte in Fig. 4 dargestellte Stellung der Kontaktstifte 36, die gegenüber der ursprünglichen Positionierung um einen halben Rasterschritt nach unten und nach rechts in Fig. 4 verschoben sind. Eine nochmalige Drehung um 90° führt zu der in Fig. 4 ganz rechts dargestellten Lage, bei der die Kontaktstifte 36 gegenüber dem ursprünglichen in Fig. 4 ganz links dargestellten Raster um einen halben Rasterschritt nach rechts verschoben sind.

Die in Fig. 4 veranschaulichten Verschiebungen der Kontaktstifte 36 durch Drehen der Umsetzer 11, 12 unter Beibehalten der den Kontaktnadeln 31 oder 32 zugeordneten Rasterpunkte ermöglicht es, Ausgleichsverschiebungen der Berührungspunkte zwischen den Kontaktflächen 3 und den abgerundeten Enden der Kontaktstifte 36 durchzuführen, so daß die Kontaktstifte 36 auch bei ungünstiger Lage der SMD-Lötflächen oder Fenster 42, 43 immer mit den Kontaktflächen 3 in Berührung gebracht werden können, ohne aufgrund der jeweiligen prüfungsspezifischen Anordnungen zwischen die Kontaktflächen 3 zu geraten.

Statt der in Fig. 1 dargestellten Ausführungsform bei der die Kontaktflächen 3 auf dem Grundadapter 1 und die Kontaktstifte 36 in den Umsetzern 11, 12 vorsehen sind, ist es auch möglich, an der Unterseite der Umsetzer 11, 12 Konaktflächen vorzusehen, denen im Grundadapter 1 Kontaktstifte entsprechend den Kontaktstiften 36 zugeordnet sind. In einem solchen Fall sind vorzugsweise auch den Tastnadeln 25 statt den Taststiften 26 Kontaktflächen zugeordnet.

## Patentansprüche

1. Vorrichtung zum Prüfen von elektrischen Leiterplatten (6) mit einer Vielzahl von gegen die Prüfpunkte (8,9,10) auf der zu prüfenden Leiterplatte (6) federnd andrückbaren und mit einer Auswerteschaltung verbundenen Nadeln (25,31,32),

EP 0 288 528 B1

wobei die Nadeln (25,31,32) auf der der zu prüfenden Leiterplatte (6) zugewandten Seite eines Zwischenadapters (13) in einem prüflingsspezifischen Muster angeordnet sind,

wobei dem Zwischenadapter (13) auf der von der Leiterplatte (6) wegweisenden Seite ein Rasterkontaktfeld (4) eines Grundadapters (1) mit einer ersten Rasterschrittweite zugeordnet ist, das über federnde Kontaktelemente (26,35,36) und eine Verdrahtung (37) an die Nadeln (25,31,32) anschließbar ist,

**dadurch gekennzeichnet,**

daß in an prüflingsspezifischen Stellen des Zwischenadapters (13) befindlichen Fenstern (42,43) prüflingsspezifische, auswechselbare Umsetzer (11,12) eingesetzt sind, die einen Teil (31,32) der Nadeln (25,31,32) aufweisen, welche den Prüfpunkten (9,10) einer zweiten Rasterschrittweite gruppenweise zugeordnet sind, und

daß die Umsetzer (11,12) auf der den Nadeln (31,32) gegenüberliegenden Seite die Kontaktelemente (35,36) in der ersten Rasterschrittweite tragen.

2. Vorrichtung nach Anspruch 1, dadurch gekennzeichnet, daß die Fenster (42,43) quadratisch sind und die Umsetzer (11,12) einen quadratischen Querschnitt aufweisen und daß die Nadeln (31,32) der Umsetzer (11,12) symmetrisch um die Längsachse (45) des Umsetzers (11,12) angeordnet sind, während das Raster der dem Rasterkontaktfeld (4) des Grundadapters (1) zu geordneten Kontaktelemente (35,36) der Umsetzer (11,12) gegenüber der Längsachse (45) um einen Bruchteil der ersten Rasterschrittweite in Richtung der beiden Rasterachsen verschoben ist.

3. Vorrichtung nach Anspruch 2, dadurch gekennzeichnet, daß die Verschiebung gegenüber der symmetrischen Anordnung ein Viertel der ersten Rasterschrittweite und die Rasterschrittweite der Nadeln (31,32) der Umsetzer (11,12) die Hälfte der ersten Rasterschrittweite beträgt.

4. Vorrichtung nach einem der Ansprüche 1 bis 3, dadurch gekennzeichnet, daß das Rasterkontaktfeld (4) ein Kontaktflächenfeld mit quadratischen Kontaktflächen (3) ist und daß die Kontaktelemente federnde Stifte (26,36) an den Umsetzern (11,12) sind.

5. Vorrichtung nach einem der Ansprüche 1 bis 3, dadurch gekennzeichnet, daß das Rasterkontaktfeld (4) federnde Stifte aufweist und daß die Kontaktelemente quadratische Kontaktflächen an den Umsetzern (11,12) sind.

6. Vorrichtung nach einem der Ansprüche 1 bis 4, dadurch gekennzeichnet, daß in den Zwischenadapter (13) Prüfpunkten der ersten Rasterschrittweite zugeordnete Nadeln (25-28) einzeln einsetzbar sind und daß sich diese Nadeln (25-28) bis zum Rasterkontaktfeld (4) erstrekken.

## Claims

1. An apparatus for testing electrical printed circuit boards (6) having a number of needles (25, 31, 32) which are adapted to be pressed resiliently on testing points (8 - 10) on the circuit board (6) to be tested and which are connected to an evaluating circuit arrangement,

the needles (25, 31, 32) being arranged in a specimen-specific pattern on that side of an intermediate adapter (13) which is near the circuit board (6) to be tested,

a modular contact zone (4) of a main adapter (1) which has a first modular step width being associated with the intermediate adapter (13) on the side extending away from the circuit board (6), such zone being connectable by way of resilient contact elements (26, 35, 36) and wiring (37) to the needles (25, 31, 32),

characterised in that

specimen-specific interchangeable converters (11, 12) are introduced in windows (42, 43) at specimen-specific places of the intermediate adapter (13) and have some (31, 32) of the needles (25, 31, 32) which are associated in groups with the testing points (9, 10) of a second modular step width, and

the converters (11, 12) carry, on the side facing the needles (31, 32) the contact elements (35, 36)in the first modular step width.

2. An apparatus according to claim 1, characterised in that the windows (42, 43) are square and the converters (11, 12) are of square cross-section and the needles (31, 32) of the converters (11, 12) are disposed symmetrically around the longitudinal axis (45) of the converter (11, 12), and the module of the converter contact elements (35, 36) which are associated with the modular contact zone (4) of the main adapter (1) are offset by a fraction of the first modular step width in the direction of the two modular axes.

3. An apparatus according to claim 2, characterised in that the offset from the symmetrical arrangement is one-quarter of thy first modular step width and the modular step width of the converter needles (21, 32) is half the first modular step width.

4. An apparatus according to any of claims 1 to 3, characterised in that the modular contact zone (4) is a contact surface zone having square contact surfaces (3) and the contact elements are resilient pins (26, 36)

5

on the converters (11, 12).

5. An apparatus according to any of claims 1 to 3, characterised in that the modular contact zone (4) has resilient pins and the contact elements are square contact surfaces on the converters (11, 12).

6. An apparatus according to any of claims 1 to 4, characterised in that needles (25 - 28) associated with testing points of the first modular step width are introducible individually into the intermediate adapter (13) and extend as far as the modular contact zone (4).


**Revendications**

1. Dispositif de contrôle de cartes de circuits imprimés électriques présentant une pluralité d'aiguilles (25, 31, 32) susceptibles d'appuyer de manière élastique sur les points à tester (8, 9, 10) et reliées à un circuit de mesure,

dans lequel les aiguilles (25, 31, 32) sont disposées sur une face d'une pièce intermédiaire d'adaptation (13) dirigée vers la carte de circuit imprimé (6) à contrôler pour former une disposition spécifique du contrôle à effectuer,

et dans lequel la pièce intermédiaire d'adaptation (13) présente, sur sa face opposée à la carte de circuit imprimé (6) une région de contact (4) en réseau d'un adaptateur principal (1) selon un premier pas de réseau, et qui est destiné à être relié aux aiguilles (25, 31, 32) par l'intermédiaire d'éléments de contact élastiques (26, 35, 36) et d'un cablage (37)

caractérisé en ce que

dans des fenêtres (42,43) de la pièce intermédiaire d'adaptation situées dans des positions spécifiques du contrôle à effectuer sont disposés des éléments de conversion (11, 12) spécifiques du contrôle à effectuer et amovibles, et qui présentent une partie (31, 32) des aiguilles (25, 31, 32) qui forment un groupe correspondant à des points de contrôle (9, 10) selon un deuxième pas de réseau,

et en ce que les éléments de conversion (11, 12) présentent, sur leur côté opposé aux aiguilles (31, 32) des éléments de contact (35, 36) selon le premier pas de réseau.

2. Dispositif selon la revendication 1, caractérisé en ce que les fenêtres sont de forme carrée, en ce que les éléments de conversion (11, 12) présentent une section carrée et en ce que les aiguilles (31, 32) des éléments de conversion (11, 12) sont disposées de manière symétrique par rapport à l'axe longitudinal (45) de l'élément de conversion (11, 12), alors que le réseau des éléments de contact (35, 36) disposé dans la région de contact (4) en réseau de l'adaptateur principal (1) est décalé par rapport à l'axe longitudinal (45).

3. Dispositif selon la revendication 2, caractérisé en ce que le décalage par rapport à une disposition symétrique est d'un quart de premier pas de réseau et en ce que le pas de réseau des aiguilles (31, 32) des éléments de conversion (11, 12) correspond à la moitié du premier pas de réseau.

4. Dispositif selon une des revendications 1 à 3, caractérisé en ce que la région de contact (4) en réseau est une région surfacique de contact présentant des surfaces carrées (3) et en ce que les éléments de contacts sont des doigts élastiques (26, 36) des éléments de conversion (11, 12).

5. Dispositif selon une des revendications 1 à 3, caractérisé en ce que la région de contact en réseau (4) présente des doigts élastiques et en ce que les éléments de contact sont des surfaces de contact carrées des éléments de conversion (11, 12).

6. Dispositif selon une des revendications 1 à 4, caractérisé en ce que la pièce intermédiaire d'adaptation (13) présente des points de contrôle séparés et faisant partie des aiguilles (25-28) disposées selon un premier pas de réseau et en ce que ces aiguilles (25-28) s'étendent jusqu'à la région de contact (4) en réseau.

Fig. 1

EP 0 288 528 B1

Fig.2

EP 0 288 528 B1

Fig. 3

• = Kontakt zum Pruefling

○ = Kontakt zur Kontaktflaeche

⊘ = nicht verdrahtet

EP 0 288 528 B1

● = Kontakt zum Pruefling

O = Kontakt zur Kontaktflaeche

Fig. 4

EP 0 288 528 B1